# EUROPEAN PATENT SPECIFICATION

(11) **EP 0 330 211 B1**
(45) Date of publication and mention of the grant of the patent: **05.01.1994**
(21) Application number: 89103217.9
(22) Date of filing: 23.02.1989
(51) Int. Cl.: H01L 39/24

(54) **Polymerised organic passivation film for a superconductor**
Polymerisierte organische Passivierungsschicht für Supraleiter
Film organique polymérisé de passivation pour supraconducteur

(30) Priority: 20.02.1989 JP 12415/89; 23.02.1988 JP 40079/88; 29.09.1988 JP 245204/88
(43) Date of publication of application: 30.08.1989
(73) Proprietor: FUJITSU LIMITED, Kawasaki-shi, Kanagawa 211 (JP)
(72) Inventor: Morohashi, Shin'ichi c/o Fujitsu Ltd., Kawasaki-shi Kanagawa 211 (JP)
(74) Representative: Sunderland, James Harry

(56) References cited:
- EP-A- 0 287 325
- EP-A- 0 301 962
- APPL. PHYS. LETT., vol. 52, no. 22, 30th May 1988, pages 1897-1898, American Institute of Physics; S. MOROHASHI et al.: "Plasma polymerization for high Tc oxide superconductors"
- DENSHI JONO TSUSHIN GAKKAI GIJUTSU KENKYU HOKOKU, vol. 88, no. 146, 1988, pages 19-22; MOROHASHI et al.: "Plasma polymerization for high-Tc oide superconductors (II)"
- APPLIED PHYSICS LETTERS, vol. 51, no. 7, 17th August 1987, pages 532-534, American Institute of Physics, New York, US; M.F. YAN et al.: "Water interaction with the superconducting YBa2Cu3O7 phase"
- APPLIED PHYSICS LETTERS, vol. 52, no. 1, 4th January 1988, pages 69-71, American Institute of Physics, New York, NY, US; S. MATSUI et al.: "Reactive ion beam etching of Y-Ba-Cu-O superconductors"
- JAPANESE JOURNAL OF APPLIED PHYSICS/PART 2 : LETTERS, vol. 27, no. 11, November 1988, pages L2088-L2090, Tokyo, JP ; K. SATO et al. : "Stabilization of Ba2YCu307-delta by surface coating with plasma polymerized fluorocarbon film"
- J. Vac. Sci. Technol. A3(6), Nov./Dec. 1985, pp. 2627-2628, R. d'Agostino.
- J. Vac. Sci. Technol. B4(6), Nov./Dec. 1986, pp. 1318-1320, C.R. Fritzsche and K. Eisele.

## Description

The present invention relates to a superconductor passivation.

Generally, a superconductor has the following nature in a fabrication process involving the superconductor; the Tc value of the superconductor is at a proper level at the beginning of the fabrication process, but, as time goes by, the properties of the superconductor deteriorate so that the Tc value and the electrical resistivity decrease and increase respectively. This has been a problem in practical use. Above all, the superconductivity properties of a superconductor are greatly affected by annealing in air and/or soaking in water; the properties are degraded. Particularly, when the superconductor is formed as a thin layer, for application of the superconductor in a microelectronic device such as a Josephson junction device, a superconducting quantum interference device (SQUID) or a hybrid device combining the superconductor and a semiconductor, problems due to humidity and/or temperature became obstacles to the fabrication of the minute electrical device.

Applied Physics Letters, Vol. 52, No. 1, 4 January 1988, pp. 69-71, S. Matsui et al, discloses Y-Ba-Cu-O superconductor films on magnesium oxide substrates. For patterning these superconductor films, a trilevel resist structure was applied. The structure comprised AZ resist on the superconductor film, then spin-on-glass, then chloromethylated polystyrene on the spin-on-glass. Cl₂ reactive ion beam etching, and argon ion beam etching are mentioned.

EP-A-0 287 325 and EP-A-0 301 962 form part of the state of the art by virtue of Article 54(3) EPC.

Applied Physics Letters, Vol. 51, No. 7, 17 August 1987, pp. 532-534, M. F. Yan et al, discusses the protection of the YBa₂Cu₃O₇ superconducting phase from adverse effects of water and water vapour by metal, glass or organic encapsulants.

Journal of Vacuum Sciences Technology, A3 (6), Nov/Dec 1985, pp 2627-2628, R. d'Agostino, discusses polymer deposition from low-pressure plasmas fed with fluorocarbons.

Reference is made also to Journal of Vacuum Sciences Technology, B4 (6), Nov/Dec 1986, pp 1318-1320, Fritsche et al.

Reference is further made to Applied Physics Letters, Vol. 52, No. 22, 30 May 1988, pp. 1897-1898, co-authored by the inventor of the present invention, and Japanese Journal of Applied Physics, Vol. 27, No. 11, November 1988, pp. L2088-L2090, K. Sato et al.

According to the present invention there is provided a superconductor device comprising:
a superconductor; and
a plasma polymerized film formed on the surface of said superconductor and comprising material including at least one of the following radicals: monofluorocarbon (CF), difluoromethane (CF₂), trifluoromethane (CF₃).

According to the present invention there is also provided a method of fabricating a superconductor device, said method comprising the steps of:-
exposing the surface of a superconductor in a plasma discharge of an organic gas with a pressure between 10 to 200 Pa, said organic gas comprising a gas selected from the groups consisting of:
a fluoroalkane or fluoroolefine group, including fluoromethane, fluoroethane, tetrafluoroethylene, hexafluoropropylene, and
a fluorohydrocarbon group, including vinylidene fluoride, vinyl fluoride, benzotrifluoride,
to form a plasma polymerized film on said surface,
said plasma polymerized film comprising material including at least one of the following radicals: monofluorocarbon (CF), difluoromethane (CF₂), trifluoromethane (CF₃).

An embodiment of the present invention can provide for improvement in the sense that a superconductor is less susceptible to the effects of humidity around the superconductor and/or temperature of the superconductor, even after the passage of time.

Embodiments of the present invention can provide for increased life of products including superconductors.

Embodiments of the present invention can provide for increased reliability of superconductors.

Embodiments of the present invention can facilitate fabrication of minute electrical devices including superconductors, so that fabrication can be performed easily and at low cost.

In accordance with an embodiment of the present invention, a superconductor is passivated by using an organic film formed on the surface of the superconductor. The organic passivation film has radicals in which carbon (C) is bonded to fluorine (F), such as difluorocarbon (CF₂), trifluorocarbon (CF₃) and monofluorocarbon (CF) radicals. The organic passivation film is a polymerized film formed on the surface of the superconductor by applying a plasma discharging method performed by setting the superconductor in a plasma chamber, and supplying fluoride compound gases thereinto. The fluoride compound gases are aliphatic hydrocarbons, including fluoroalkanes such as fluoromethane (CH₄₋ₓFₓ), and fluoroethane (C₂H₆₋ₓFₓ), fluoroolefines such as tetrafluoroethylene (C₂F₄), hexafluoropropylene (C₃F₆) and fluorohydrocarbons such as vinylidene fluoride (CH₂CF₂), vinyl fluoride (CH₂CHF) or benzotrifluoride (C₆H₅CF₃) (e.g. including aromatic fluorohydrocarbons).

Embodiments of the present invention provide a superconductor passivated by an organic film and a method of forming the organic film onto a surface of the superconductor. The organic film is effective for preventing or mitigating deterioration of superconduction properties of the superconductor for example as a result of annealing in air and/or soaking in water.

The organic passivation film will be called a "plasma polymerized film" here.

In an embodiment of the invention, the plasma polymerized film is formed on the superconductor and protects the superconductor from adverse effects of humidity around the superconductor, water pulled onto the superconductor and the temperature of the superconductor itself, so that the superconductivity properties can be maintained without, or with less, deterioration with the passage of time. Applying the plasma polymerized film to the surface of the superconductor, water-resisting and heat-resisting properties of the superconductor can be maintained, or maintained more nearly, at levels presented at an initial time of fabrication; in other words, the problems of decreasing Tc value and/or increasing resistivity of the superconductor can be mitigated. Therefore, when the superconductor passivated by the plasma polymerized film is fabricated as a thin layer and applied to a minute electrical device such as the Josephson junction device, the minute electrical device can be more easily fabricated, for example, by performing patterning, using an organic solvent such as acetone, acid such as nitric acid and hydrofluoric acid and water.

Superconductivity properties of a superconductor which have deteriorated with the passage of time can be recovered to an approximately initial state by supplying an oxygen gas, mixing with the fluoride compound gases when the plasma polymerized film is formed in the plasma chamber.

Reference is made, by way of example, to the accompanying drawings, in which:-
Fig. 1 is a schematic drawing of a parallel plate-type plasma generating apparatus;
Fig. 2 is a schematic cross-sectional view of a sample consisting of a substrate, a superconductor film and a plasma polymerized film;
Fig. 3 is the XPS spectrum of the C₁ₛ electron in a plasma polymerized film formed on a YBaCuOₓ superconductor;
Fig. 4 is the infrared reflection spectra of a plasma polymerized film formed on a Si substrate;
Fig. 5 is the XPS spectrum of the Y_{3d} electron at the interface between the plasma polymerized film and the YBaCuOₓ superconductor;
Fig. 6 is the XPS spectrum of the Y_{3d} electron at a surface of an as-grown YBaCuOₓ superconductor;
Fig. 7 is a graph showing the temperature dependence of the resistivity of a coated YBaCuOₓ superconductor, under three different conditions or circumstances;
Fig. 8 is a graph showing the temperature dependence of the resistivity of an uncoated YBaCuOₓ superconductor before and after soaking in water;
Fig. 9 is a graph showing the temperature dependence of the resistivity of an uncoated YBaCuOₓ superconductor after different heat treatments;
Fig. 10 is a graph showing the temperature dependence of the resistivity of a coated BiSrCaCuOₓ superconductor after soaking in water;
Fig. 11 is a graph showing the temperature dependence of the resistivity of an uncoated BiSrCaCuOₓ superconductor before and after soaking in water;
Fig. 12(a) is an oscilloscopic display showing the current-voltage characteristics of an uncoated YBaCuOₓ superconductor;
Fig. 12(b) is an oscilloscopic display showing the current-voltage characteristics of a coated YBaCuOₓ superconductor under a condition of mixing the source gas with oxygen;
Fig. 13(a) is a schematic cross-sectional view of a sample of a ceramic superconductor (YBaCuOₓ) layer formed on a substrate (SrTiO₃) and coated by a plasma polymerized film, for illustrating an initial step of a patterning process;
Fig. 13(b) is a schematic cross-sectional view of a sample provided by coating a resist film on the plasma polymerized film shown in Fig. 13(a);
Fig. 13(c) is a schematic cross-sectional view of a sample provided by projecting a pattern onto the resist film shown in Fig. 13(b);
Fig. 13(d) is a schematic cross-sectional view of a sample provided by resist-coating and patterning the sample shown in Fig. 13(c);
Fig. 13(e) is a schematic cross-sectional view of a sample, for illustrating a step of pattern etching performed on the plasma polymerized film shown in Fig. 13(d), by an argon ion etching method;
Fig. 13(f) is a schematic cross-sectional view of a sample, for illustrating a step of pattern etching performed on the ceramic superconductor layer shown in Fig. 13(e), by an reactive ion etching method; and
Fig. 13(g) is a schematic cross-sectional view of the patterned ceramic superconductor layer, for illustrating a final step of removing the resist film and the plasma polymerized film in Fig. 13(f).

As is known, a superconductor has a critical temperature (Tc) below which it exhibits the superconduction effect. Previously, when the Tc values of superconductors were low, for example at liquid helium temperatures, it was difficult to put superconductors to practical use. However, recently, Tc values have been raised to significantly higher levels as a result of worldwide studies of superconductor materials. For instance, the Tc value of a superconductor using a material belonging to a lanthanum-strontium-copper oxide (LaSrCuOₓ) group is 40K, that belonging to a yttrium-barium-copper oxide (YBaCuOₓ) group is 90K and that belonging to a bismuth-strontium-calcium-copper oxide (BiSrCaCuOₓ) group is 105K. Superconductors made of these high Tc materials are generally called "high Tc superconductors", and as will be seen from the materials mentioned above, the high Tc superconductors are "ceramic superconductors". Thus, although it has been difficult to put superconductors to practical use, the development of ceramic superconductors has reduced the difficulties. Therefore, in relation to embodiments of the present invention, ceramic superconductors will be primarily discussed.

A ceramic superconductor can easily be fabricated in bulk or as a thin layer. A bulk superconductor body is fabricated by a conventional rubber press method, and a thin layer is formed on a substrate made of a single crystal such as silicon, strontium-titanium oxide (SrTiO₃), aluminum oxide (sapphire-Al₂O₃) or magnesium oxide (MgO), by an electron beam (EB) evaporating method, a sputtering method or a molecular beam epitaxial (MBE) method. Superconductors fabricated into thin layers are of most immediate practical value, for instance in application to minute electrical devices, so that in relation to the embodiments of the present invention, thin layers of ceramic superconductor will be primarily discussed.

In accordance with embodiments of the present invention, a polymerized organic film fabricated by a plasma discharging method is used as a passivation film for preventing deterioration of the superconduction properties of a superconductor from occurring with the passage of time, because of the effects of humidity for instance.

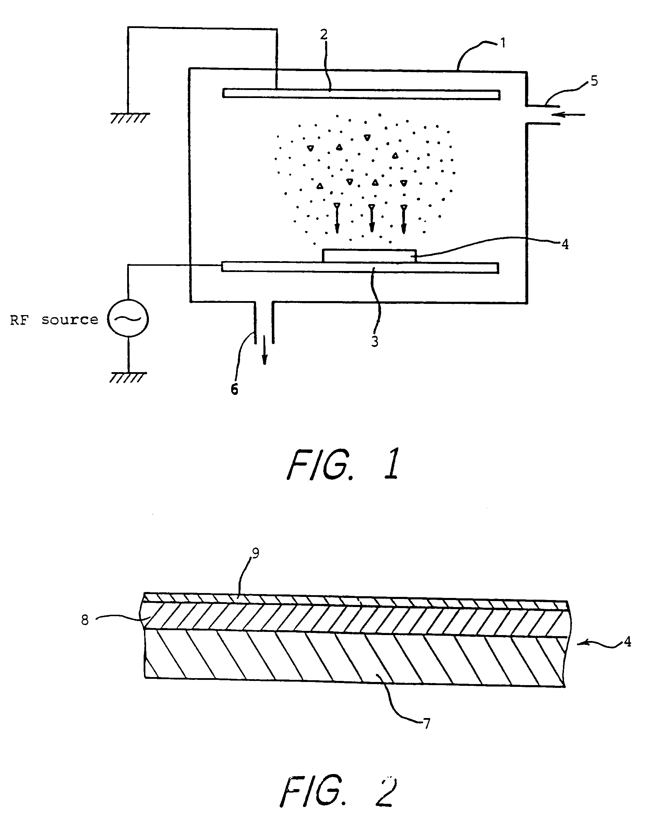

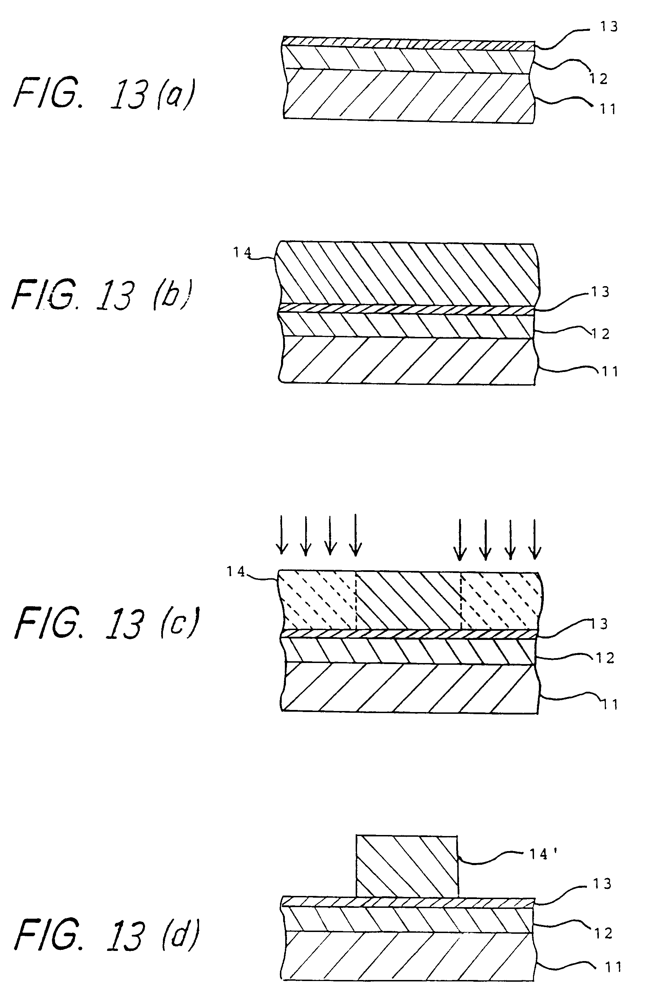

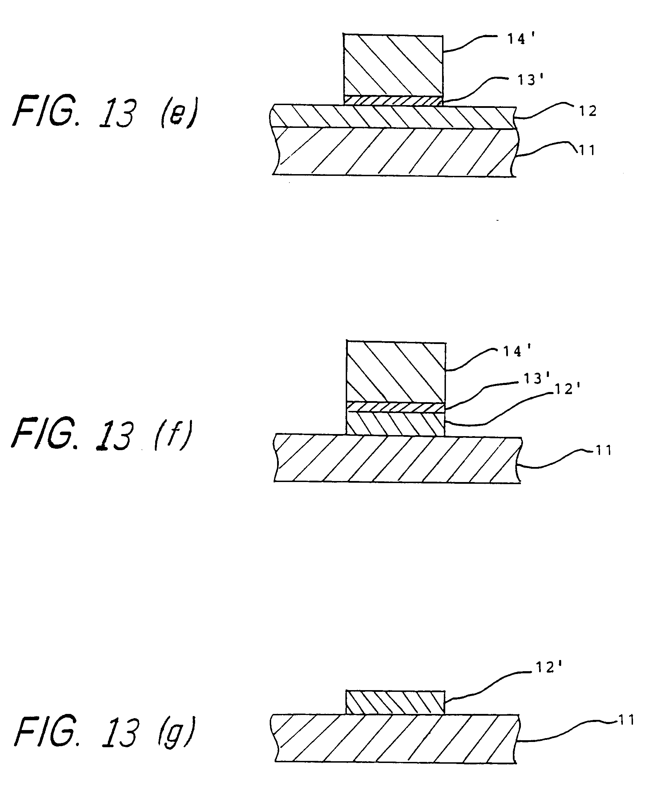

In relation to embodiments of the present invention, the plasma polymerized organic film, which will be simply called the "plasma polymerized film", formed on a ceramic superconductor fabricated as thin layer will be primarily discussed, with reference to Figs. 1 and 13.

In relation to a first embodiment of the present invention, the plasma polymerized film formed for passivation on a ceramic superconductor YBaCuOₓ will be discussed, together with a method of forming plasma polymerized film, with reference to Fig. 1.

Fig. 1 is a schematic illustration of a parallel plate-type plasma generating apparatus for forming the plasma polymerized film on the ceramic superconductor. In Fig. 1, a chamber 1 is evacuated by a vacuum pump, which is not depicted in Fig. 1, down to a pressure of an order of 1.33 Pascal (Pa). A source gas for the plasma discharging is supplied to the chamber 1 through a gas inlet 5 and exhausted through a gas outlet 6 attached to the chamber 1. A pair of plate electrodes 2 and 3, each having a 300 cm² area, are in the chamber 1, and radio frequency (RF) power is applied from an RF power supply (RF) to the plate electrode 3, with the plate electrode 2 grounded. Then, plasma is generated in the region provided between the plate electrodes 2 and 3. A sample 4 composed of an insulating substrate 7 and a ceramic superconductor 8 (see Fig. 2) made of YBaCuOₓ in a thin layer (for instance 100 to 200 nm thick) formed on the surface of the insulating substrate 7 is placed on the plate electrode 3. The insulating substrate 7 is generally made of material such as SrTiO₃, Al₂O₃ or MgO, and is made of SrTiO₃ for example in this first embodiment.

In order to form a plasma polymerized film 9 on the ceramic superconductor 8 as shown in Fig. 2, trifluoromethane (CHF₃), being a kind of fluoromethane, is used as the source gas under a pressure between about 13.3 and 199.5 Pascal (Pa) (10 to 200 Pa), and RF power less than 0.64 W/cm² is applied for 10 minutes. The period of applying the RF power, 10 minutes here, is generally called discharging time. Then the plasma polymerized film 9 is formed on the surface of the ceramic superconductor 8 so as to have a thickness of 10 to 50 nm, by controlling the RF power, the discharging time and/or the pressure of the source gas. Thicknesses in the range 0.5 nm to 100 nm may be employed.

A ceramic superconductor passivated by a plasma polymerized film formed using a plasma discharging apparatus as mentioned above was examined and compared with the usual ceramic superconductor not passivated by the plasma polymerized film, for confirming the merits of the plasma polymerized film. That is, the superconductivity of the ceramic superconductor passivated by the plasma polymerized film, the composition of the plasma polymerized film and the passivation effect of the plasma polymerized film were measured or confirmed, and the following results were obtained, wherein the formation of the plasma polymerized film will be simply called the "plasma treatment", the ceramic superconductor passivated by the plasma polymerized film will be simply called the "film-coated ceramic superconductor" and the ceramic superconductor not passivated by the plasma polymerized film will be simply called the "film-uncoated ceramic superconductor" hereinafter.

First, the superconduction properties of the film-coated ceramic superconductor are as follows: the Tc value is nearly constantly 80K before and after the plasma treatment independent of the pressure of the CHF₃ source gas; and a resistivity ratio, at 20°C, of the film-coated ceramic superconductor to the film-uncoated ceramic superconductor is unity at 66.5 Pa and 199.5 Pa pressure points of the source gas and is slightly larger than unity at 26.6 Pa and 133 Pa pressure points of the source gas.

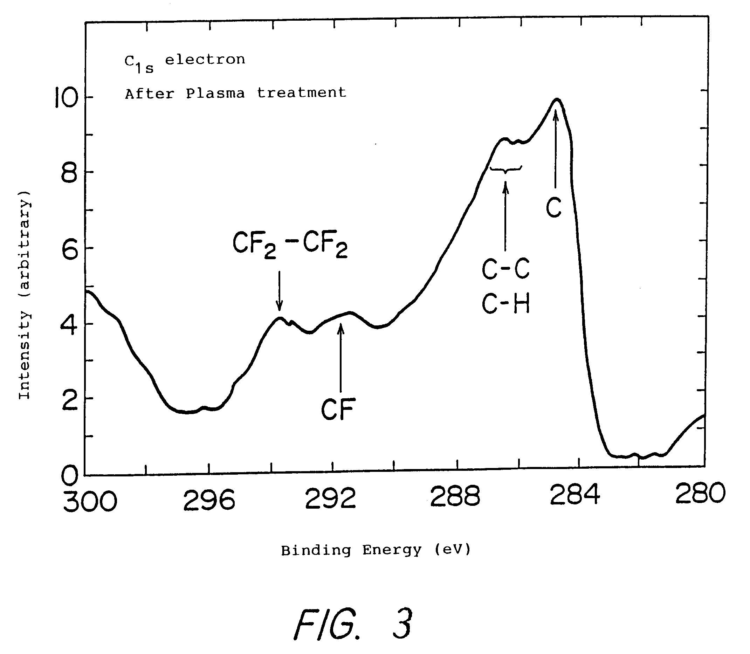

Second, the composition, analyzed by spectroscopic means, of the plasma polymerized film is as shown in Figs. 3 to 6. That is:
Fig. 3 shows a spectrum of the plasma polymerized film obtained by X-ray photoelectron spectroscopy (XPS). In Fig. 3, the relative intensity of emission of the carbon 1s electron (C₁ₛ) is plotted against its binding energy. From the spectrum in Fig. 3, it can be determined that the spectral peaks indicated by four arrows in Fig. 3 indicate that CF₂-CF₂, C-F, C-C and C-H radicals and free carbon exist in the plasma polymerized film.

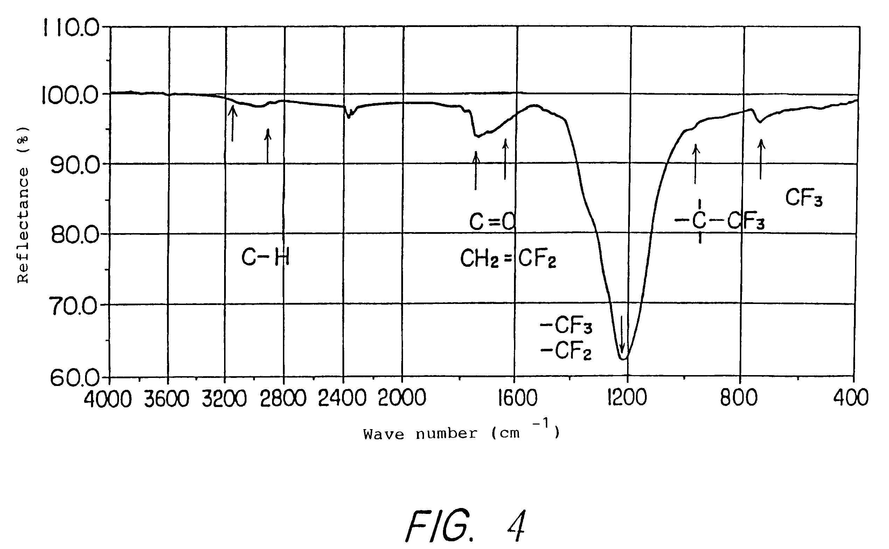

Fig. 4 shows an infrared reflection spectrum of the plasma polymerized film formed on a silicon substrate instead of the SrTiO₃ substrate. In Fig. 4, the reflectance of the film is plotted against wave number, and from Fig. 4, it can be determined that the spectral signals indicated by arrows in Fig. 4 indicate that C-H, C=O, CH₂=CF₂, C-F, CF₃ and C-CF₃ radicals exist in the plasma polymerized film. In these radicals, C=O and C-H radicals are not important, because the C=O and C-H radicals are produced only in a process of reaction occurring between C in the plasma polymerized film and O in the air or C in the plasma polymerized film and H in the air after the plasma polymerized film is formed.

From Figs. 3 and 4, it is confirmed that the plasma polymerized film includes at least (one of) the monofluorocarbon (CF) radical, the difluorocarbon (CF₂) radical and the trifluorocarbon (CF₃) radical.

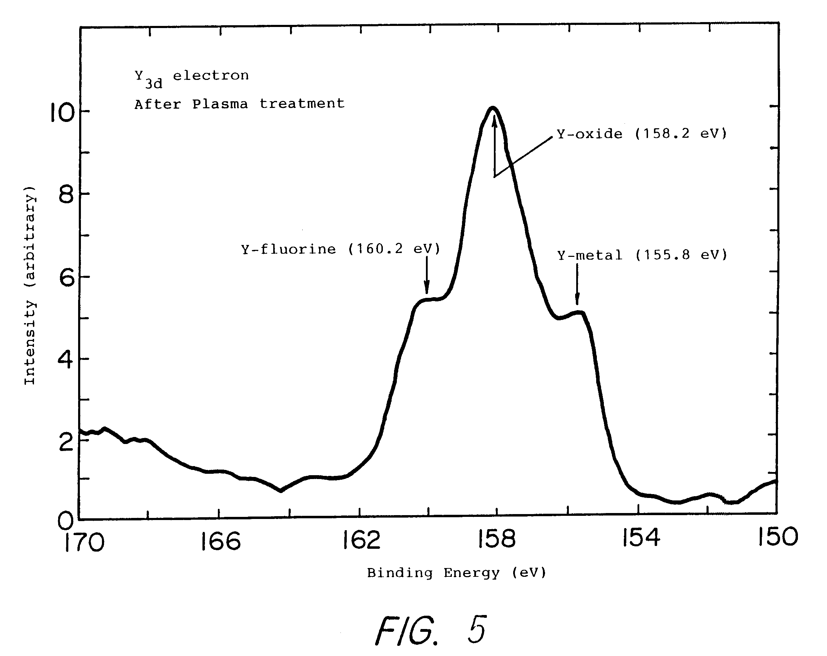

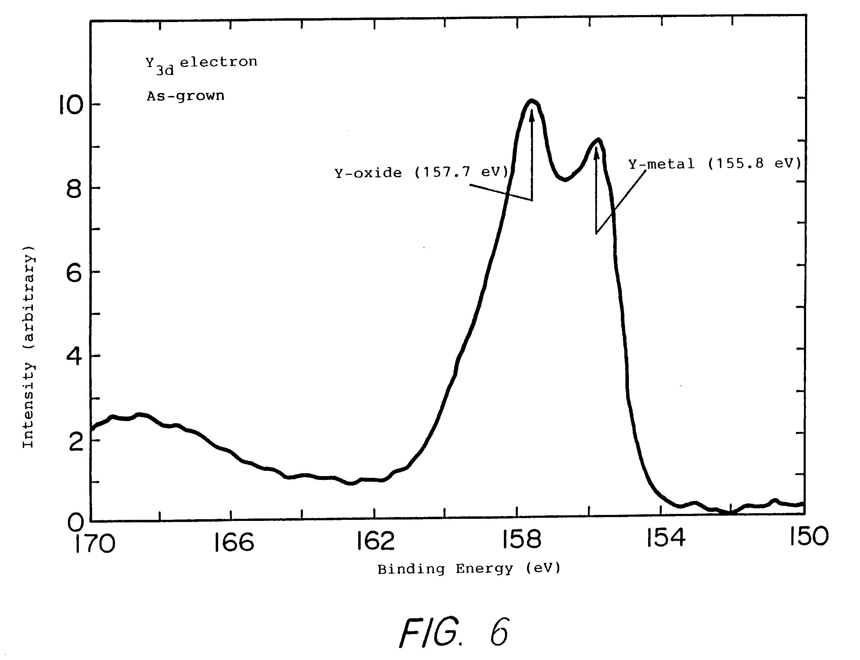

The chemical properties of the interface region between the plasma polymerized film and the ceramic superconductor are analyzed by XPS as shown in Figs. 5 and 6. The relative intensity of emission from the 3d electron of yttrium (Y_{3d}) is plotted against its binding energy in Figs. 5 and 6 respectively for cases in which the film-coated ceramic superconductor and the film-uncoated ceramic superconductor are analysed. Investigating the spectra in Figs. 5 and 6, it can be seen that an extra spectral peak due to an yttrium-fluorine bond (Y-F) exists at 160.2eV and that two other spectral peaks due to yttrium metal and yttrium oxide exist in Fig. 5 and these other spectral peaks appear in both Figs. 5 and 6. Though there is no data in Figs. 5 and 6, the existence of a Ba-F bond and a Cu-F bond in the interface region can be confirmed by comparing spectra of the film-coated and uncoated ceramic superconductors. From the fact that there are Y-F, Ba-F and Cu-F bonds at the interface region, it can be concluded that the chemical reaction between the source gas and the ceramic superconductor (YBaCuOₓ) takes place sufficiently even at the beginning of the plasma discharging. This means that the plasma polymerized film is tightly coated on the surface of the ceramic superconductor.

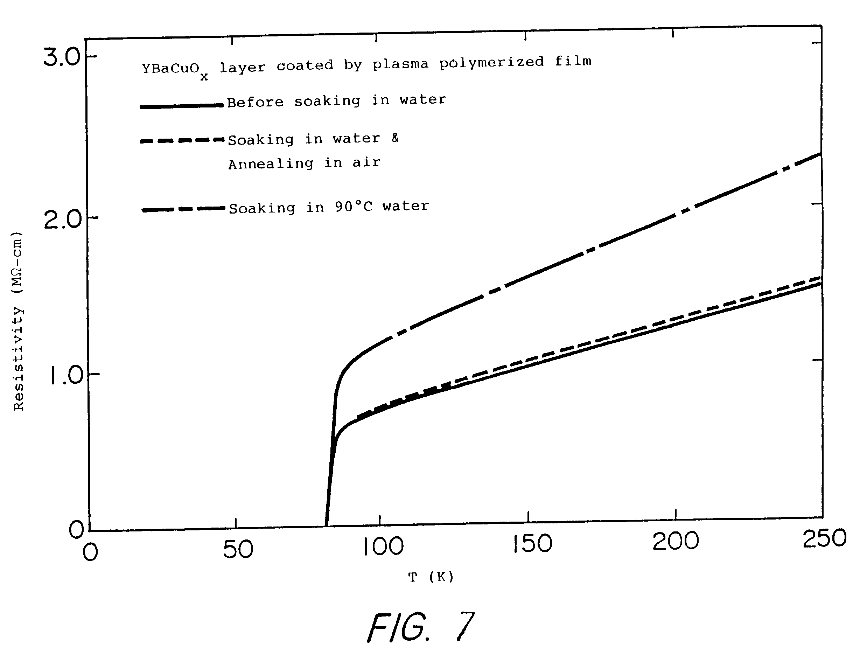

Third, the passivation effect of the plasma polymerized film for preventing deterioration, due to annealing in air and/or soaking in water, of the superconductivity of the ceramic superconductor is confirmed by measuring the resistivity of the ceramic superconductor, and comparing the film-coated ceramic superconductor with the film-uncoated ceramic superconductor. The confirmation is apparent from the data shown in Figs. 7 to 11, as follows:
Fig. 7 shows the relationship between the resistivity and the temperature of the film-coated ceramic superconductor, measured under several different conditions or circumstances. In Fig. 7, the solid curve indicates resistivity, depending on temperature, of the film-coated ceramic superconductor. From the solid curve, it is found that the temperature at the cross-point of the solid curve and the abscissa is the Tc value, which is 80K in Fig. 7. The broken-line curve indicates also resistivity of the film-coated ceramic superconductor but in this case the film-coated ceramic superconductor has been initially soaked in the water at 20°C then put in the air at 200°C for 30 minutes, for examining deterioration of superconductivity due to annealing in air and/or soaking in water. Comparing the solid curve with the broken-line curve, it can be seen that the Tc value and the resistivity indicated by these curves are almost the same. After the measurement of resistivity, the same sample was soaked again in water at 90°C for 10 minutes and taken out in air at 200°C for 30 minutes, then the resistivity of the film-coated superconductor layer was again measured. The result of the measurement is shown by the chain-line curve. From the chain-line curve, it can be seen that the Tc value does not change even though the resistivity increases by approximately 50%.

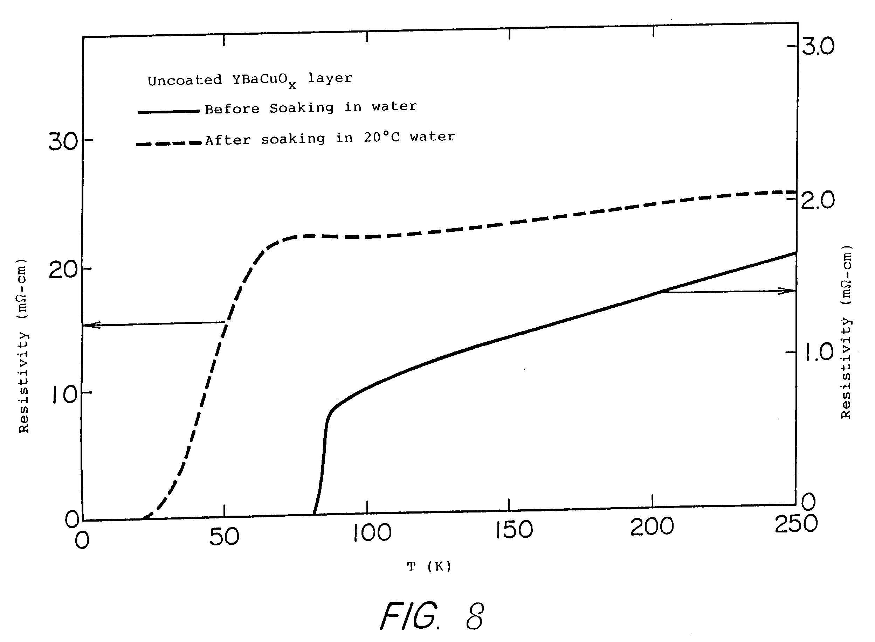

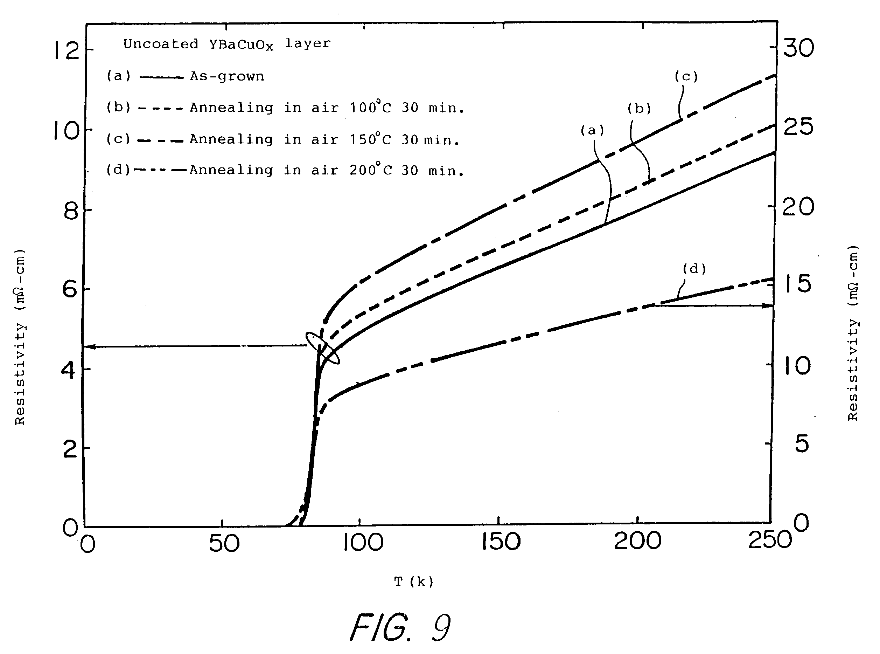

The relationship between resistivity, measured under several conditions or circumstances, and the temperature of the film-uncoated ceramic superconductor is shown in Figs. 8 and 9. Fig. 8 relates to the influence of humidity on the resistivity of the film-uncoated ceramic superconductor and Fig. 9 relates to the effect of the temperature on the resistivity of the film-uncoated ceramic superconductor.

In Fig. 8, the solid curve shows the resistivity of the film-uncoated ceramic superconductor before soaking in water and the broken-line curve shows the resistivity after soaking in water at 20°C for 60 minutes. Comparing the solid curve with the broken-line curve, it can be seen that the respective Tc values are quite different from one another. In the case of the solid curve, the Tc value is 80K but in the case of the broken-line curve, the Tc value is 17K, from which it can be concluded that the Tc value of the film-uncoated ceramic superconductor is easily affected by humidity.

In Fig. 9, the deterioration, due to annealing in air, of the resistivity of the film-uncoated ceramic superconductor is indicated. In Fig. 9, the curve (a), the solid curve, indicates the resistivity of an as-grown film-uncoated ceramic superconductor having a Tc value of 79K. The curve (b), the broken-line curve, indicates the resistivity of the film-uncoated ceramic superconductor having been heated in air at 100°C for 30 minutes. The curve (c), the chain-line curve, indicates resistivity of the film-uncoated ceramic conductor having been heated in air at 150°C for 30 minutes. For curves (a), (b) and (c) resistivity should be read from the lefthand-side scale. Curve (d), a double chain-line curve, indicates resistivity of the film-uncoated ceramic conductor having been heated in air at 200°C for 30 minutes, and in this case, resistivity should be read from the righthand-side scale.

From Fig. 9, it can been seen that when the film-uncoated ceramic superconductor is heated up, the resistivity of the film-uncoated ceramic superconductor increases to two or three times the resistivity of an as-grown film-uncoated ceramic superconductor, and the Tc value decreases by several degrees.

From the description of the first embodiment given above, particularly with reference to Figs. 7, 8 and 9, it will be clear that the plasma polymerized film offers a great advantage in relation to the prevention of deterioration, due to annealing in air and/or soaking in water, of the superconductivity of the ceramic superconductor.

The plasma polymerized film used in the first embodiment can be used also for passivating a ceramic superconductor made of BiSrCaCuOₓ.

A second embodiment of the present invention is concerned with a plasma polymerized film for passivating a ceramic superconductor which will be called the "BiSrCaCuOₓ superconductor" hereinafter, for distinguishing the ceramic superconductor used in this second embodiment from the ceramic superconductor, made of YBaCuOx, used in the first embodiment.

The BiSrCaCuOₓ superconductor is formed, as a thin layer, on a substrate made of, in this case, MgO, by applying a conventional RF magnetron spattering method. Then, the plasma polymerized film is formed on the BiSrCaCuOₓ superconductor in the chamber 1 shown in Fig. 1. In the chamber 1, the plasma polymerized film is formed on BiSrCaCuOₓ superconductor using CHF₃ as a source gas having a pressure of 133 Pa and a flow rate of 40 ml/min. and applying an RF power of 0.32 W/cm² for a plasma discharging time of 30 minutes.

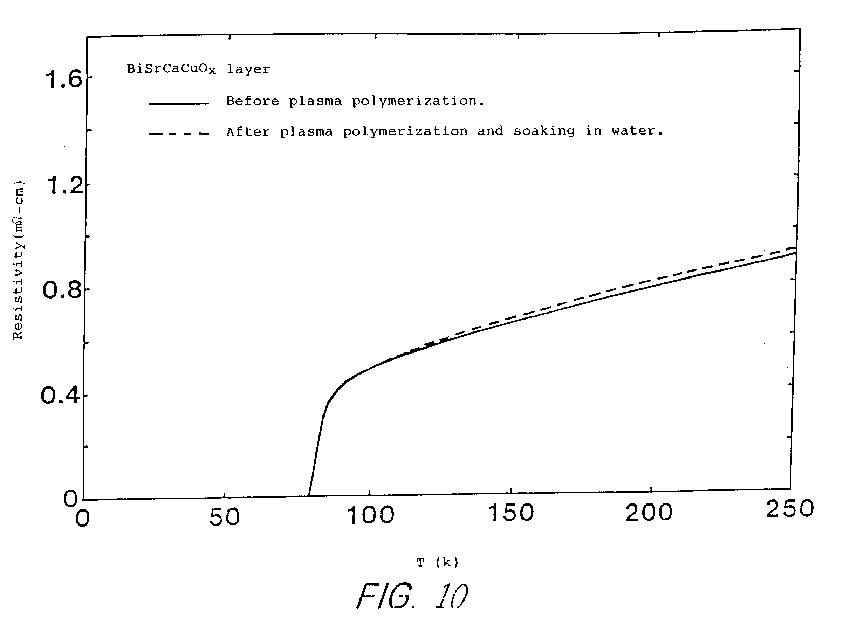

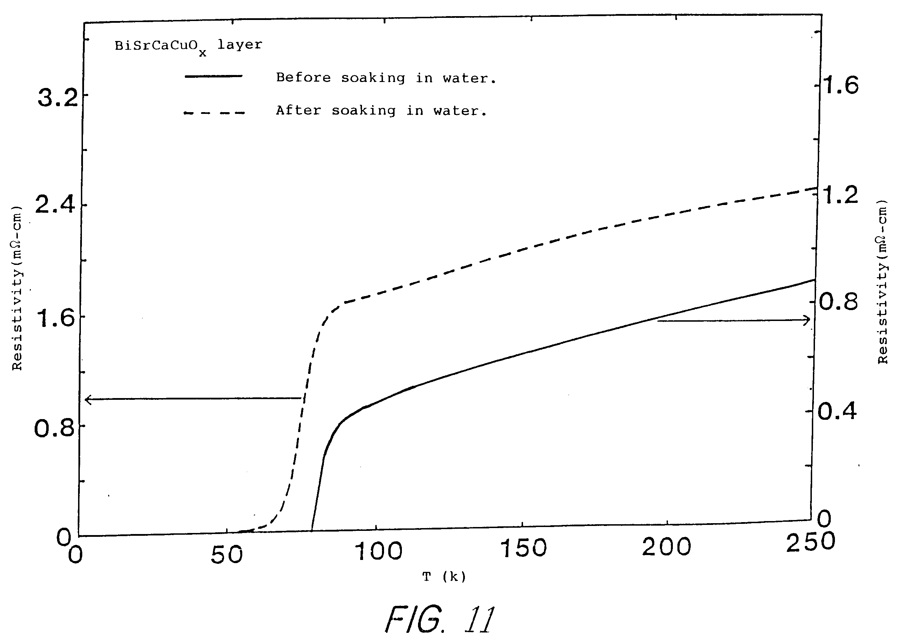

Similarly to the case of the first embodiment, the passivation effect of the plasma polymerized film was investigated by soaking in water. The results of the investigation are as shown in Figs. 10 and 11.

Incidentally, layer thickness and gas pressures similar to those mentioned in relation to the first embodiments can be used in relation to this second embodiment, and other embodiments of the invention, for instance those described below.

Fig. 10 shows the relationship between resistivity of the BiSrCaCuOₓ superconductor and the measuring temperature. In Fig. 10, the solid curve indicates the resistivity of an as-grown film of uncoated BiSrCaCuOₓ superconductor having a Tc value of 78K, and the broken-line curve indicates the resistivity of film-coated BiSrCaCuOₓ superconductor, coated with a plasma polymerized film 240 nm thick, after soaking in water at 20°C for 5 hours. From Fig. 10, it can be concluded that the plasma polymerized film is effective against deterioration of superconduction properties due to humidity because, as seen in Fig. 10, the increase of resistivity is only 3% and the Tc value is not changed.

Fig. 11 shows the relationship between the resistivity of the BiSrCaCuOₓ superconductor and the measuring temperature. In Fig. 11, the solid curve is the resistivity of an as-grown film of uncoated BiSrCaCuOₓ superconductor having been soaked in water at 20°C for 1 hour. From Fig. 11, it can be concluded that if the BiSrCaCuOₓ superconductor is not passivated by the plasma polymerized film, the superconduction property is such as the Tc value and the resistivity of the BiSrCaCuOₓ superconductor are greatly deteriorated by soaking in water because, as seen in Fig. 11, the Tc value is decreased to 57K and the resistivity is increased by two or three times, compared with the superconduction property of the BiSrCaCuOₓ superconductor not affected by soaking in water.

In a third embodiment of the present invention a plasma polymerized film is provided not only for protecting characteristics of the superconductor from deterioration (as caused by soaking in water and/or in air) but also for recovering characteristics once degraded.

In the third embodiment, the plasma polymerized film, the ceramic superconductor and the insulating substrate are the same as those in the first embodiment. The plasma polymerized film is formed on the ceramic superconductor in a thin layer state in chamber 1 as described in relation to the first embodiment with reference to Fig. 1. However, in this case oxygen is mixed in the usual source gas of CHF₃. The conditions used for performing the plasma treatment in this case are as follows: the content of oxygen can be varied up to 50%, however 10% is preferable; the pressure of the source gas is 133 Pa; and the RF power is 0.32 W/cm².

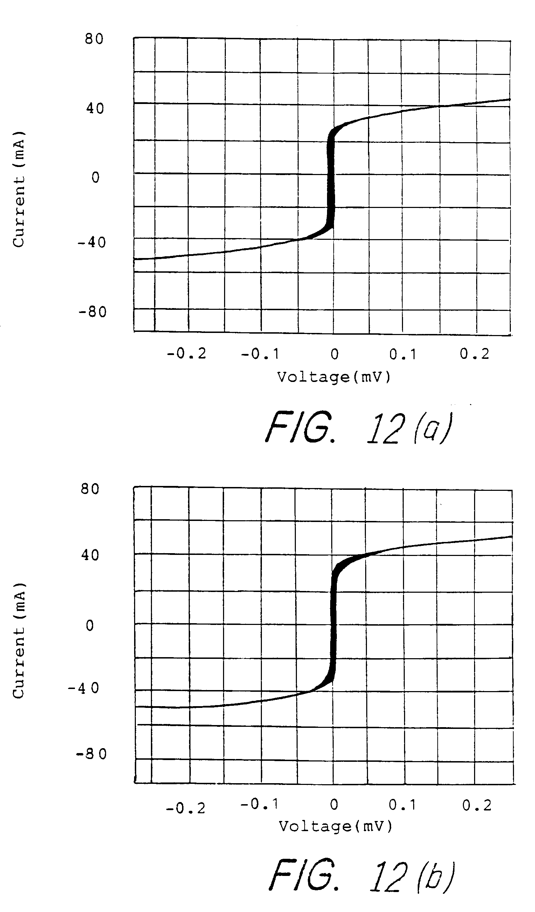

The effect of mixing the oxygen is shown in Figs. 12(a) and 12(b). Fig. 12(a) shows current-voltage characteristics of a film-uncoated ceramic superconductor operating at 60K, the superconductor being, however, such that several days have passed from the time when the superconductor was fabricated. Fig. 12(b) shows the current-voltage characteristics of the same ceramic superconductor as in Fig. 12(a) with the plasma polymerized film formed thereon. In Fig. 12(a) and 12(b), the currents read from the vertical portions of the respective curve are called critical current. As seen from Figs. 12(a) and 12(b), the value of the critical current in Fig. 12(b) is larger than that in Fig. 12(a), which is considered to indicate that the oxygen (used in the plasma treatment) provides for recovery of superconducting characteristics. This recovery phenomenon in a superconductor has been known as a laboratory phenomenon. However, practical application of the recovery phenomenon has not been possible prior to the "combination" of the recovery phenomenon with the plasma polymerized film formed on the ceramic superconductor as in the present invention. This is because the recovered superconducting characteristics are maintained only when the superconducting layer is passivated by the plasma polymerized film of the present invention.

A fourth embodiment of the present invention is concerned with the application of a plasma polymerized film to the fabrication process of a minute electrical device including a superconductor. In the fabrication process of the minute electrical device, a patterning process is indispensable, to integrate minute electrical devices such as Josephson junction devices and SQUIDs.

A patterning process for a ceramic superconducting film will be described with reference to Figs. 13(a) and 13(b).

In Fig. 13(a), a superconductor (YBaCuOₓ) layer 12 is formed on a substrate (SrTiO₃) 11 by a conventional method. As a substrate, Al₂O₃ or MgO is also applicable. However, a superconductor made of YBaCuOₓ is usually formed on a substrate made of SrTiO₃, whilst a superconductor made of BiSrCaCuOₓ is usually formed on a substrate made of MgO, with a view to eliminating problems of lattice mismatching. The thickness of the YBaCuOₓ superconductor layer 12 is usually 100 to 200 nm. Then, a plasma polymerized film 13 is formed on the YBaCuOₓ superconductor layer 12 in the same way as described with reference to the first embodiment. The thickness of the plasma polymerized film 13 is controlled so as to be in a range from 0.5 to 100 nm by adjusting the pressure of the source gas, the RF power and the plasma discharging time. The thickness of the plasma polymerized film 13 is set to usually 10 to 50 nm. A resist film 14 of about 500 nm thick is coated on the surface of the plasma polymerized film 13, by a spinner, as shown in Fig. 13(b). Then, the resist film 14 is exposed using a photomask (not depicted) as indicated by arrows in Fig. 13(c). The exposed section is removed by a developer and then washed by water, producing a resist pattern 14' as shown in Fig. 13(d). The process of developing the exposed resist becomes possible because the plasma polymerized film 13 protects the ceramic superconduction layer from water and acid such as the developer.

Then, the plasma polymerized film 13 is pattern-etched by an argon ion etching technique. The argon ion etching can be performed in the chamber 1 of the plasma generating apparatus shown in Fig. 1, by exchanging the gas in the chamber 1. Typical conditions for argon ion etching are that the pressure of argon is 1.3 Pa and the RF power of the plasma generating apparatus is in the range of 1.3 to 2.6 W/cm². In Fig. 13(e), a pattern-etched plasma polymerized film 13' provided by the method described above is shown.

Next, the YBaCuOₓ superconductor layer 12 is pattern-etched by a reactive ion etching technique, using tetrachloromethane (CCl₄). The reactive ion etching is performed in the plasma generating apparatus. The reactive ion etching is performed under the conditions that the pressure of the CCl₄ is 6.5 Pa and the RF power is in the range of 0.3 to 0.6 W/cm². A pattern-etched YBaCuOₓ superconductor layer 12' is shown in Fig. 13(f). If a wet etching technique is used to pattern-etch the YBaCuOₓ superconductor layer 12, the peripheral side of the YBaCuOₓ superconductor layer 12' is also etched. However, this is usually not important because the superconductor layer 12' is very thin.

Finally, the pattern-etched resist film 14' and the pattern-etched plasma polymerized film 13' are removed by applying oxygen plasma ashing and argon ion etching, leaving the patterned YBaCuOₓ superconductor layer 12'. Conditions for the oxygen plasma ashing are that the pressure of oxygen is 13 Pa and RF power is in the range of 0.3 to 0.6 W/cm². Thus, the patterning of the YBaCuOₓ superconductor is accomplished as shown in Fig. 13(g).

In all the above embodiments, the CHF₃ gas is typically used to fabricate the plasma polymerized film. However, a C₂F₄ gas or a mixed gas of a CF₄ gas and an H₂ gas are also useful.

Further, the following gases, i.e. gases of the fluoroalkane group such as fluoromethane and fluoroethane, fluoroolefines such as hexafluoropropylene, gases of the fluorohydrocarbon group such as vinylidene fluoride, vinyl fluoride and gases of the aromatic fluorohydrocarbon group such as benzotrifluoride can be used as a source gas under the same conditions as CHF₃ gas.

In an embodiment of the present invention a ceramic superconductor layer formed on a substrate is passivated by a plasma polymerized film formed on a surface of the ceramic superconductor layer so as to have a thickness of 0.5 to 100 nm, by a conventional plasma discharging method using an organic gas such as a trifluoromethane gas. According to spectroscopic analysis, the plasma polymerized film includes fluorocarbon radicals, and further, bonding between fluorine and elements of the ceramic superconductor, e.g. yttrium, barium and copper, is observed at the interface between the ceramic superconductor layer and the plasma polymerized film. A miniature electronic device including the ceramic superconductor layer can be fabricated by conventionally patterning the ceramic superconductor layer passivated by the plasma polymerized film, using any solvent.

## Claims

1. A superconductor device comprising:
a superconductor; and
a plasma polymerized film formed on the surface of said superconductor and comprising material including at least one of the following radicals: monofluorocarbon (CF), difluoromethane (CF₂), trifluoromethane (CF₃).

2. A superconductor device as claimed in claim 1, wherein said superconductor is provided as a ceramic superconductor layer formed on the surface of a substrate of the device.

3. A superconductor device as claimed in claim 2, wherein said plasma polymerized film further comprises material including fluorides chemically bonded with elements of material composing said ceramic superconductor layer, at an interface existing between said plasma polymerized film and said ceramic superconductor layer.

4. A superconductor device as claimed in claim 2 or 3, wherein said substrate comprises one of the following substances: silicon, strontium titanate, alumina and magnesium oxide.

5. A superconductor device as claimed in claim 2, 3 or 4, wherein said ceramic superconductor layer comprises lanthanum-strontium-copper oxide, yttrium-barium-copper oxide or bismuth-strontium-calcium-copper oxide.

6. A superconductor device as claimed in claim 2, 3, 4 or 5, wherein said plasma polymerized film has a thickness in the range from 0.5 to 100nm.

7. A superconductor device as claimed in claim 2, 3, 4, 5 or 6, wherein said ceramic superconductor layer has a thickness in the range from 100 to 200nm.

8. A method of fabricating a superconductor device, said method comprising the steps of:-
exposing the surface of a superconductor in a plasma discharge of an organic gas with a pressure between 10 to 200 Pa, said organic gas comprising a gas selected from the groups consisting of:
a fluoroalkane or fluoroolefine group, including fluoromethane, fluoroethane, tetrafluoroethylene, hexafluoropropylene, and
a fluorohydrocarbon group, including vinylidene fluoride, vinyl fluoride, benzotrifluoride,
to form a plasma polymerized film on said surface,
said plasma polymerized film comprising material including at least one of the following radicals: monofluorocarbon (CF), difluoromethane (CF₂), trifluoromethane (CF₃).

9. A method as claimed in claim 8, wherein the superconductor is formed as a ceramic superconductor layer on a substrate.

10. A method as claimed in claim 9, wherein the ceramic superconductor layer, formed on the substrate, is patterned by a method of patterning comprising the steps of:-
(1) forming said plasma polymerized film on a surface of the ceramic superconductor layer, using said organic gas;
(2) coating a resist film on said plasma polymerized film;
(3) patterning said resist film for producing a resist pattern;
(4) etching the plasma polymerized film by an argon ion etching technique, using said resist pattern as a mask, for producing a patterned plasma polymerized film under the resist pattern;
(5) etching the ceramic superconductor layer by a reactive ion etching technique, using the resist pattern as a mask, for producing a patterned ceramic superconductor layer on the substrate where the resist pattern, and said patterned plasma polymerized film remains on the substrate;
(6) removing the resist pattern and the patterned plasma polymerized film by oxygen plasma ashing, leaving the patterned ceramic superconductor layer.

11. A method as claimed in claim 10, wherein step (1) is performed by using plasma generating means.

12. A method as claimed in claim 10 or 11, wherein step (1) is performed so that said plasma polymerized film has a thickness in the range from 0.5 to 100nm.

13. A method as claimed in claim 10, 11 or 12, wherein step (2) is performed by using a spinner so that the resist film has a thickness of approximately 500nm.

14. A method as claimed in claim 10, 11, 12 or 13, wherein step (3) is performed by processes comprising exposing a previously designated light pattern onto a resist film, developing the exposed resist film by a developing solution and washing the developed resist film with water.

## Patentansprüche

1. Supraleiteranordnung, mit:
einem Supraleiter; und
einem plasmapolymerisierten Film, der auf der Fläche des genannten Supraleiters gebildet ist und Material umfaßt, das zumindest eines der folgenden Radikale enthält: Monofluorkohlstoff (CF), Difluormethan (CF₂), Trifluormethan (CF₃).

2. Supraleiteranordnung nach Anspruch 1, bei welcher der genannte Supraleiter als keramische Supraleiterschicht, die auf der Fläche eines Substrats der Anordnung gebildet ist, vorgesehen ist.

3. Supraleiteranordnung nach Anspruch 2, bei welcher der genannte plasmapolymerisierte Film ferner Material umfaßt, das Fluoride, die mit Elementen des die genannte keramische Supraleiterschicht bildenden Materials chemisch gebunden sind, an einer zwischen dem genannten plasmapolymerisierten Film und der genannten keramischen Supraleiterschicht vorliegenden Grenzfläche enthält.

4. Supraleiteranordnung nach Anspruch 2 oder 3, bei welcher das genannte Substrat eine der folgenden Substanzen umfaßt: Silizium, Strontiumtitanat, Aluminiumoxid und Magnesiumoxid.

5. Supraleiteranordnung nach Anspruch 2, 3 oder 4, bei welcher die genannte keramische Supraleiterschicht Lanthanstrontiumkupferoxid, Yttriumbariumkupferoxid oder Wismutstrontiumkupferoxid umfaßt.

6. Supraleiteranordnung nach Anspruch 2, 3, 4 oder 5, bei welcher der genannte plasmapolymerisierte Film eine Dicke im Bereich von 0,5 bis 100 nm aufweist.

7. Supraleiteranordnung nach Anspruch 2, 3, 4, 5 oder 6, bei welcher die genannte keramische Supraleiterschicht eine Dicke im Bereich von 100 bis 200 nm aufweist.

8. Verfahren zur Herstellung einer Supraleiteranordnung, welches Verfahren die Schritte umfaßt:
Exponieren der Fläche eines Supraleiters in einer Plasmaentladung eines organischen Gases mit einem Druck zwischen 10 und 200 Pa, wobei das genannte organische Gas ein Gas umfaßt, das ausgewählt ist aus der Gruppe bestehend aus:
einer Fluoralkan- oder Fluorolefin-Gruppe, einschließlich Fluormethan, Fluorethan, Tetrafluorethylen, Hexafluorpropylen, und
einer Fluorkohlenwasserstoff-Gruppe, einschließlich Vinylidenfluorid, Vinylfluorid, Benzotrifluorid,
um einen plasmapolymerisierten Film auf der genannten Fläche zu bilden,
wobei der genannte plasmapolymerisierte Film Material umfaßt, das zumindest eines der folgenden Radikale enthält: Monofluorkohlenstoff (CF), Difluormethan (CF₂), Trifluormethan (CF₃).

9. Verfahren nach Anspruch 8, bei welchem der Supraleiter aus einer keramischen Supraleiterschicht auf einem Substrat gebildet wird.

10. Verfahren nach Anspruch 9, bei welchem die keramische Supraleiterschicht, die auf dem Substrat gebildet wird, durch ein Musterungsverfahren gemustert wird, das die Schritte umfaßt:
(1) Bilden des genannten plasmapolymerisierten Films auf einer Fläche der keramischen Supraleiterschicht unter Verwendung des genannten organischen Gases;
(2) Aufbringen eines Resistfilms auf dem genannten plasmapolymerisierten Film;
(3) Mustern des genannten Resistfilms zur Erzeugung eines Resistmusters;
(4) Ätzen des plasmapolymerisierten Films durch eine Argon-Ionenätztechnik unter Verwendung des genannten Resistmusters als Maske zur Erzeugung eines gemusterten plasmapolymerisierten Films unter dem Resistmuster;
(5) Ätzen der keramischen Supraleiterschicht durch ein reaktives Ionenätzverfahren unter Verwendung des Resistmusters als Maske zur Erzeugung einer gemusterten keramischen Supraleiterschicht auf dem Substrat, wo das Resistmuster und der genannte gemusterte plasmapolymerisierte Film auf dem Substrat verbleiben;
(6) Entfernen des Resistmusters und des gemusterten plasmapolymerisierten Films durch Sauerstoffplasmaveraschung, wobei die gemusterte keramische Supraleiterschicht zurückbleibt.

11. Verfahren nach Anspruch 10, bei welchem Schritt (1) unter Verwendung einer plasmaerzeugenden Einrichtung durchgeführt wird.

12. Verfahren nach Anspruch 10 oder 11, bei welchem Schritt (1) durchgeführt wird, so daß der genannte plasmapolymerisierte Film eine Dicke im Bereich von 0,5 bis 100 nm aufweist.

13. Verfahren nach Anspruch 10, 11 oder 12, bei welchem Schritt (2) unter Verwendung einer Schleuder durchgeführt wird, so daß der Resistfilm eine Dicke von ungefähr 500 nm aufweist.

14. Verfahren nach Anspruch 10, 11, 12 oder 13, bei welchem Schritt (3) durch Prozesse durchgeführt wird, die das Belichten eines Resistfilms mit einem vorher ausgebildeten Lichtmuster, Entwickeln des belichteten Resistfilms mit einer Entwicklungslösung und Waschen des entwickelten Resistfilms mit Wasser umfassen.

## Revendications

1. Dispositif supraconducteur comprenant :
un supraconducteur ; et
un film polymérisé plasma formé sur la surface dudit supraconducteur et comprenant un matériau incluant au moins l'un des radicaux suivants : monofluorocarbone (CF), difluorométhane (CF₂), trifluorométhane (CF₃).

2. Dispositif supraconducteur selon la revendication 1, dans lequel ledit supraconducteur est constitué en tant que couche supraconductrice en céramique formée sur la surface d'un substrat du dispositif.

3. Dispositif supraconducteur selon la revendication 2, dans lequel ledit film polymérisé plasma comprend en outre un matériau incluant des fluorures chimiquement liés avec des éléments du matériau composant ladite couche supraconductrice en céramique, au niveau d'une interface existant entre ledit film polymérisé plasma et ladite couche supraconductrice en céramique.

4. Dispositif supraconducteur selon la revendication 2 ou 3, dans lequel ledit substrat comprend l'une des substances suivantes : du silicium, du titanate de strontium, de l'alumine et de l'oxyde de magnésium.

5. Dispositif supraconducteur selon la revendication 2, 3 ou 4, dans lequel ladite couche supraconductrice en céramique comprend de l'oxyde de lanthane-strontium-cuivre, de l'oxyde d'yttrium-baryum-cuivre ou de l'oxyde de bismuth-strontium-calcium-cuivre.

6. Dispositif supraconducteur selon la revendication 2, 3, 4 ou 5, dans lequel ledit film polymérisé plasma présente une épaisseur qui s'inscrit dans une plage qui va de 0,5 à 100 nm.

7. Dispositif supraconducteur selon la revendication 2, 3, 4, 5 ou 6, dans lequel ladite couche supraconductrice en céramique présente une épaisseur qui s'inscrit dans une plage qui va de 100 à 200 nm.

8. Procédé de fabrication d'un dispositif supraconducteur, ledit procédé comprenant les étapes de :
mise à nu de la surface d'un supraconducteur dans une décharge plasma d'un gaz organique moyennant une pression comprise entre 10 et 200 Pa, ledit gaz organique comprenant un gaz choisi parmi les groupes comprenant :
un groupe fluoroalcane ou fluorooléfine, incluant du fluorométhane, du fluoroéthane, du tétrafluoroéthylène, de l'hexafluoropropylène ; et
un groupe fluorohydrocarbone, incluant du fluorure de vinylidène, du fluorure de vinyl, du benzotrifluorure,
afin de former un film polymérisé plasma sur ladite surface,
ledit film polymérisé plasma comprenant un matériau incluant au moins l'un des radicaux suivants : monofluorocarbone (CF), difluorométhane (CF₂), trifluorométhane (CF₃).

9. Procédé selon la revendication 8, dans lequel le supraconducteur est formé en tant que couche supraconductrice en céramique sur un substrat.

10. Procédé selon la revendication 9, dans lequel la couche supraconductrice en céramique formée sur le substrat est conformée au moyen d'un procédé de conformation comprenant les étapes de :
(1) formation dudit film polymérisé plasma sur une surface de la couche supraconductrice en céramique en utilisant ledit gaz organique ;
(2) dépôt d'un film de réserve sur ledit film polymérisé plasma ;
(3) conformation dudit film de réserve pour produire un motif de réserve ;
(4) gravure du film polymérisé plasma au moyen d'une technique de gravure ionique argon en utilisant ledit motif de réserve en tant que masque pour produire un film polymérisé plasma conformé sous le motif de réserve ;
(5) gravure de la couche supraconductrice en céramique au moyen d'une technique de gravure ionique réactive en utilisant le motif de réserve en tant que masque pour produire une couche supraconductrice en céramique conformée sur le substrat, le motif de réserve et ledit film polymérisé plasma conformé restant sur le substrat ;
(6) enlèvement du motif de réserve et du film polymérisé plasma conformé au moyen d'une destruction par plasma d'oxygène en laissant la couche supraconductrice en céramique conformée.

11. Procédé selon la revendication 10, dans lequel l'étape (1) est réalisée en utilisant un moyen de génération de plasma.

12. Procédé selon la revendication 10 ou 11, dans lequel l'étape (1) est réalisée de telle sorte que ledit film polymérisé plasma présente une épaisseur qui s'inscrit dans une plage qui va de 0,5 à 100 nm.

13. Procédé selon la revendication 10, 11 ou 12, dans lequel l'étape (2) est réalisée en utilisant un dispositif de revêtement à la tournette de telle sorte que le film de réserve présente une épaisseur d'approximativement 500 nm.

14. Procédé selon la revendication 10, 11, 12 ou 13, dans lequel l'étape (3) est réalisée au moyen de processus comprenant l'exposition d'un motif de lumière conçu préalablement sur un film de réserve, de développement du film de réserve exposé à l'aide d'une solution de développement et de lavage du film de réserve développé avec de l'eau.
